# EUROPÄISCHE PATENTSCHRIFT

(11) **EP 2 342 769 B1**
(45) Veröffentlichungstag und Bekanntmachung des Hinweises auf die Patenterteilung: **30.03.2016**
(21) Anmeldenummer: 09771674.0
(22) Anmeldetag: 19.10.2009
(51) Int. Cl.: H01L 51/00, H01L 51/50

(54) **ORGANISCHES, STRAHLUNGSEMITTIERENDES BAUELEMENT UND VERFAHREN ZUR HERSTELLUNG EINES SOLCHEN**
ORGANIC, RADIATION-EMITTING COMPONENT AND METHOD FOR PRODUCING THE SAME
COMPOSANT RAYONNANT ORGANIQUE ET PROCÉDÉ DE FABRICATION D'UN TEL COMPOSANT

(30) Priorität: 30.10.2008 DE 102008054052
(43) Veröffentlichungstag der Anmeldung: 13.07.2011
(73) Patentinhaber: OSRAM OLED GmbH, 93049 Regensburg (DE)
(72) Erfinder: POPP, Michael, 80538 München (DE); RIEGEL, Nina, 93105 Tegernheim (DE)
(74) Vertreter: Epping - Hermann - Fischer
(86) Internationale Anmeldenummer: PCT/DE2009/001450
(87) Internationale Veröffentlichungsnummer: WO 2010/048923

(56) Entgegenhaltungen:
- WO-A1-2007/091805
- WO-A2-2008/111850
- US-B1- 6 337 102

## Beschreibung

Es wird ein Verfahren zur Herstellung eines organischen, strahlungsemittierenden Bauelements angegeben. Darüber hinaus wird ein organisches, strahlungsemittierendes Bauelement angegeben.

Die Druckschrift US 7,285,907 B2 beschreibt ein organisches, strahlungsemittierendes Bauelement.

Die Druckschrift Dl (WO 2008/111850 A2) beschreibt die Herstellung von metallorganischen Verbindungen mittels ALCVD (atomic layer chemical vapour deposition).

Eine zu lösende Aufgabe besteht darin, ein organisches, strahlungsemittierendes Bauelement anzugeben, das gegenüber dem Stand der Technik einfacher herstellbar ist. Eine weitere zu lösende Aufgabe besteht unter anderem darin, ein Verfahren zur Herstellung eines solchen Bauelements anzugeben.

Diese Aufgabe wird gelöst durch ein Verfahren zur Herstellung eines organischen, strahlungsemittierenden Bauelements, bei dem der strahlungsemittierende Bereich zumindest zwei Schichten 11 umfasst, die jeweils aus zumindest einem Matrixmaterial bestehen und mittels Atomlagenabscheidung hergestellt werden, wobei zumindest eine Schicht 10, die ein Emittermaterial enthält, zwischen zwei Schichten 11 aus Matrixmaterial angeordnet ist, wobei die zumindest eine Schicht 10 eine Dicke von höchstens 2 nm aufweist, wobei das Matrixmaterial durch ein fluoreszierendes Emittermaterial gebildet ist, das eingerichtet ist, Strahlung im Wellenlängenbereich von blauem Licht zu emittieren, und wobei in dem strahlungsemittierenden Bereich zumindest eine weitere Schicht 10 und damit zumindest zwei Schichten 10 erzeugt werden, die mittels Atomlagenabscheidung hergestellt werden und jeweils ein voneinander unterschiedliches phosphoreszierendes Emittermaterial enthalten, das dazu eingerichtet ist, Strahlung mit größeren Wellenlängen als blaues Licht zu emittieren.

Gemäß zumindest einer Ausführungsform des Verfahrens zur Herstellung eines organischen, strahlungsemittierenden Bauelements wird bei der Herstellung des Bauelements ein strahlungsemittierender Bereich erzeugt. Bei dem strahlungsemittierenden Bereich des Bauelements handelt es sich um denjenigen Bereich, der bei Beaufschlagung des Bauelements mit einem elektrischen Strom, das heißt im Betrieb des Bauelements, elektromagnetische Strahlung erzeugt. Der strahlungsemittierende Bereich des Bauelements umfasst also zumindest eine Schicht, in der durch Rekombination von Ladungsträgern elektromagnetische Strahlung erzeugt wird.

Gemäß zumindest einer Ausführungsform des Verfahrens wird bei der Herstellung des strahlungsemittierenden Bereichs des Bauelements zumindest eine Schicht erzeugt, die ein Emittermaterial enthält. Bei dieser Schicht handelt es sich dann um eine Emissionsschicht, in der bei Betrieb des Bauelements mittels Rekombination von Ladungsträgern elektromagnetische Strahlung erzeugt wird. Bei dem Emittermaterial handelt es sich vorzugsweise um ein organisches Material.

Gemäß zumindest einer Ausführungsform des Verfahrens zur Herstellung eines organischen, strahlungsemittierenden Bauelements wird zumindest die Schicht, die ein Emittermaterial enthält, mittels Atomlagenabscheidung (ALD - Atomic Layer Deposition) hergestellt. Bei der Atomlagenabscheidung handelt es sich um eine Variante der chemischen Dampfphasenabscheidung (CVD - Chemical Vapor Deposition). Bei der Atomlagenabscheidung findet dabei ein Schichtwachstum in zyklischer Weise statt. Dabei wird bei jedem Zyklus eine gewisse Menge des abzuscheidenden Materials abgeschieden. Jeder Zyklus kann dabei zwischen zirka 0,5 und mehreren Sekunden dauern, wobei pro Zyklus zirka 0,1 bis 3 Ǻ an Dicke der abgeschiedenen Schicht erzeugt werden. Das heißt, mittels der Atomlagenabscheidung ist es möglich, geringe Schichtdicken der Emitterschicht zu erzeugen. Die Schichtdicke hängt dabei lediglich von der Zahl der Zyklen ab, was eine besonders exakte und einfache Steuerung der Schichtdicke erlaubt. Das heißt, über die Steuerung der Beschichtungszeit kann auf sehr einfache Weise eine vorgegebene Schichtdicke besonders exakt gewachsen werden. Es handelt sich daher bei der Atomlagenabscheidung um ein besonders gut reproduzierbares Verfahren.

Gemäß zumindest einer Ausführungsform des Verfahrens zur Herstellung eines organischen, strahlungsemittierenden Bauelements beträgt die Dicke der zumindest einen Schicht, die ein Emittermaterial enthält, weniger als 5 nm, vorzugsweise höchstens 2 nm. Darüber hinaus sind aber noch dünnere Schichtdicken möglich. So ist es möglich, dass die Dicke einer Schicht, die ein Emittermaterial enthält, höchstens eine Monolage beträgt oder im Submonolagenbereich liegt.

Das heißt, mittels der Atomlagenabscheidung ist das Erzeugen von sehr dünnen Emitterschichten möglich. Die Menge des Emittermaterials, das heißt, die Dotierungskonzentration des Emittermaterials kann auf besonders einfache Weise über die Dauer der Abscheidung des Emittermaterials bestimmt werden. Auf diese Weise entfallen umständliche, sonst notwendige und zeitaufwändige Stabilisationen der Abscheideraten, wie das beispielsweise bei anderen Verdampfungsverfahren der Fall ist. Ferner ist mittels der Atomlagenabscheidung die Kombination von mehreren Materialien, beispielsweise die Kombination von loch- und elektronenleitenden Materialien, besonders gut möglich.

Es ist dabei möglich, dass sämtliche Schichten des strahlungsemittierenden Bereichs mittels Atomlagenabscheidung hergestellt werden. Das heißt, der gesamte strahlungsemittierende Bereich ist dann mittels Atomlagenabscheidung hergestellt.

Gemäß zumindest einer Ausführungsform des hier beschriebenen Verfahrens zur Herstellung eines organischen, strahlungsemittierenden Bauelements wird in einem strahlungsemittierenden Bereich des Bauelements zumindest eine Schicht erzeugt, die ein Emittermaterial enthält, wobei die Schicht mittels Atomlagenabscheidung hergestellt wird. Die Dicke der Schicht beträgt dabei höchstens 2 nm.

Es wird darüber hinaus ein organisches, strahlungsemittierendes Bauelements angegeben. Gemäß zumindest einer Ausführungsform des organischen, strahlungsemittierenden Bauelements umfasst das Bauelement einen strahlungsemittierenden Bereich, in den im Betrieb des Bauelements elektromagnetische Strahlung erzeugt wird. Die elektromagnetische Strahlung wird vorzugsweise durch Rekombination von Ladungsträgern erzeugt.

Das Organische, strahlungsemittierende Bauelement weist einen strahlungsemittierenden Bereich auf, in dem im Betrieb des Bauelements elektromagnetische Strahlung erzeugt wird,
bei dem der strahlungsemittierende Bereich zumindest zwei Schichten 11 umfasst, die jeweils aus zumindest einem Matrixmaterial bestehen, wobei zumindest eine Schicht 10, die ein Emittermaterial enthält, zwischen zwei Schichten 11 aus Matrixmaterial angeordnet ist, wobei die zumindest eine Schicht (10) eine Dicke von höchstens 2 nm aufweist,
das Matrixmaterial durch ein fluoreszierendes Emittermaterial gebildet ist, das eingerichtet ist, Strahlung im Wellenlängenbereich von blauem Licht zu emittieren, und der strahlungsemittierende Bereich zumindest eine weitere Schicht 10 und damit zumindest zwei Schichten 10 umfasst, die jeweils ein voneinander unterschiedliches phosphoreszierendes Emittermaterial enthalten, das dazu eingerichtet ist, Strahlung mit größeren Wellenlängen als blaues Licht zu emittieren.

Gemäß zumindest einer Ausführungsform des organischen, strahlungsemittierenden Bauelements umfasst das strahlungsemittierende Bauelement dabei zumindest eine Schicht, die ein Emittermaterial enthält und eine Dicke von höchstens 2 nm aufweist.

Eine solch dünne Schicht aus oder mit Emittermaterial ist besonders einfach mittels Atomlagenabscheidung herstellbar. Aufgrund einer solch dünnen Schicht mit Emittermaterial sind eine sehr effiziente Injektion und ein gesteigerter Ladungsträgereinfang in der Schicht mit Emittermaterial möglich. Das hier beschriebene Bauelement zeichnet sich daher durch eine erhöhte Effizienz aus. Darüber hinaus ist aufgrund der Verwendung der Atomlagenabscheidung von einzelnen Schichten des Bauelements eine Steuerung der Schichtdicke bis in den monomolekularen und submolekularen Bereich möglich. Das heißt, bis in den monomolekularen und submolekularen Bereich sind beliebige Materialkombinationen im Aufdampfprozess herstellbar, wodurch eine strikte Aufteilung der Strukturfolgen im strahlungsemittierenden Bereich aufgelöst wird. Dies erlaubt es, organische, strahlungsemittierende Bauelemente herzustellen, die besonders gut an ihre Einsatzerfordernisse angepasst werden können. Im Gegensatz dazu zeigen bekannte organische, strahlungsemittierende Bauelemente einen Schichtaufbau mit begrenzter Schichtanzahl und einer minimalen Schichtdicke im Bereich von 5 nm. Der Schichtaufbau ist dabei strikt eingeteilt in funktionelle Schichten wie Elektronen- und Lochleiter, Elektronen- und Lochbarriereschichten und Schichten mit Emittermaterial.

Im Folgenden werden vorteilhafte Ausführungsformen für das hier beschriebene Verfahren sowie das hier beschriebene, organische, strahlungsemittierende Bauelement aufgeführt. Die in diesem Zusammenhang offenbarten Merkmale beziehen sich dabei jeweils sowohl auf das Verfahren zur Herstellung, als auch auf das herzustellende organische, strahlungsemittierende Bauelement.

Gemäß zumindest einer Ausführungsform enthält das strahlungsemittierende Bauelement im strahlungsemittierenden Bereich zumindest zwei Schichten, die jeweils ein Emittermaterial enthalten. Bei den Emittermaterialien der Schichten kann es sich um das gleiche oder um unterschiedliche Emittermaterialien handeln. Der strahlungsemittierende Bereich kann dabei zwei, drei oder mehr Schichten, die jeweils ein Emittermaterial enthalten, aufweisen. Dabei können die Schichten paarweise unterschiedliches Emittermaterial umfassen, oder einige der Schichten bis hin zu allen Schichten können das gleiche Emittermaterial enthalten.

Gemäß zumindest einer Ausführungsform sind die zumindest zwei Schichten, die jeweils ein Emittermaterial enthalten, dabei mittels Atomlagenabscheidung hergestellt. Das heißt, zwei, mehr oder sämtliche Schichten des Bauelements, die ein Emittermaterial enthalten, werden mittels Atomlagenabscheidung hergestellt.

Gemäß zumindest einer Ausführungsform wird im strahlungsemittierenden Bereich des Bauelements zumindest eine Schicht erzeugt, die aus zumindest einem Matrixmaterial besteht. Die Schicht kann dabei aus einem lochleitenden Matrixmaterial bestehen. Ferner kann die Schicht aus einem elektronenleitenden Matrixmaterial bestehen. Vorzugsweise umfasst die Schicht zumindest zwei Matrixmaterialien: zumindest ein elektronenleitendes Matrixmaterial und zumindest ein lochleitendes Matrixmaterial, die in der Schicht miteinander vermischt sein können. Die Schicht kann dabei ebenfalls mittels Atomlagenabscheidung hergestellt werden, was eine besonders gute Kontrolle der Schichtdicke erlaubt.

Beispielsweise kann zur Herstellung des strahlungsemittierenden Bereichs abwechselnd das Abscheiden einer Schicht, die zumindest aus einem Matrixmaterial besteht, und einer Schicht, die zumindest ein Matrixmaterial enthält, das mit einem Emittermaterial dotiert ist, erfolgen. Das heißt, Matrixmaterial und Matrixmaterial mit Emittermaterial werden abwechselnd mittels Atomlagenabscheidung hergestellt.

Es hat sich dabei gezeigt, dass diese Struktur - insbesondere wenn sie mit Atomlagenabscheidung hergestellt wird - den Ladungsträgereinfang in den Schichten, die ein Emittermaterial enthalten, verbessert. Dabei kann die Schichtdicke einer jeden Schicht individuell bis in den Monolagen - oder Submonolagen-Bereich eingestellt werden. Das heißt, sowohl Schichten, die aus zumindest einem Matrixmaterial bestehen, als auch Schichten, die ein Emittermaterial enthalten, können Dicken unterhalb von 0,5 nm aufweisen.

Gemäß zumindest einer Ausführungsform umfasst der strahlungsemittierende Bereich zumindest eine Schicht, die aus zumindest einem Barrierematerial besteht, wobei das Barrierematerial eine größere Bandlücke als das Matrixmaterial aufweist.

Bei dem Barrierematerial handelt es sich beispielsweise um ein elektronenblockierendes Material, ein lochblockierendes Material oder besonders bevorzugt um eine Kombination aus einem elektronenblockierenden Material und einem lochblockierenden Material. Die zumindest eine Schicht, die ein Barrierematerial enthält, ist dabei vorzugsweise ebenfalls mittels Atomlagenabscheidung erzeugt. Das heißt, auch die Dicke dieser Schicht kann höchstens 2 nm oder darunter betragen.

Beispielsweise kann auch die Dicke dieser Schicht im Monolagen- oder Submonolagen-Bereich liegen. Dabei ist es möglich, dass sich im strahlungsemittierenden Bereich des Bauelements Schichten, die zumindest ein Barrierematerial enthalten, mit Schichten, die ein Emittermaterial enthalten, abwechseln. Eine derartige Anordnung verbessert den Einfang von Ladungsträgern in den Schichten, die ein Emittermaterial enthalten, weiter. Eine derartige Struktur ist beispielsweise mit Quantentöpfen in einem anorganischen Halbleitermaterial vergleichbar. Das heißt, die hier beschriebene Struktur könnte auch als organische Quantentopfstruktur beschrieben werden.

Gemäß zumindest einer Ausführungsform umfasst der strahlungsemittierende Bereich zumindest zwei Schichten, die jeweils aus zumindest einem Barrierematerial bestehen, wobei zumindest eine Schicht, die ein Emittermaterial enthält, zwischen diesen zwei Schichten angeordnet ist. Das organische, strahlungsemittierende Bauelement kann dabei in seinem strahlungsemittierenden Bereich eine Mehrzahl von Schichten mit Emittermaterial aufweisen, die jeweils zwischen zwei Schichten aus zumindest einem Barrierematerial angeordnet sind.

Dadurch ist mit anderen Worten ein strahlungsemittierender Bereich angegeben, der eine Vielzahl von organischen Quantentöpfen umfasst. Das Barrierematerial verbessert dabei den Einfang von Ladungsträgern in der Emissionszone, das heißt, in den Schichten, die ein Emittermaterial enthalten. Die Schichten aus zumindest einem Barrierematerial können dabei ein Dicke im Bereich von wenigen Monolagen bis hin zum Submonolagenbereich aufweisen. Sie steuern die Injektion von Ladungsträgern in den Schichten, die ein Emittermaterial enthalten. Sämtliche Schichten können dabei beispielsweise mittels Atomlagenabscheidung erzeugt werden. Auf diese Weise ist eine besonders genaue Kontrolle der Schichtdicken möglich.

Gemäß zumindest einer Ausführungsform ist das Matrixmaterial zumindest einer Schicht im strahlungsemittierenden Bereich des Bauelements durch ein Emittermaterial gebildet, das eingerichtet ist, Strahlung im Wellenlängenbereich von blauem Licht zu emittieren. In dieses Matrixmaterial kann dann zumindest eine Schicht, vorzugsweise mehrere Schichten, eingebracht sein, die ein Emittermaterial enthalten. Dieses Emittermaterial ist dann geeignet, Strahlung im größeren Wellenlängenbereich als blaues Licht zu emittieren. Bei dem Emittermaterial in den Schichten handelt es sich beispielsweise um ein phosphoreszierendes Emittermaterial. Das Emittermaterial, welches das Matrixmaterial für das Emittermaterial in den Schichten bildet, kann fluoreszierend sein. Dabei ist es auch möglich, dass Ladungsträger nicht direkt vom Emittermaterial in den Schichten eingefangen werden, sondern dass Ladungsträger zunächst vom energetisch höher liegenden Emittermaterial des Matrixmaterials hin zu den energetisch tiefer liegenden Emittermaterialien der Schichten nicht strahlend relaxieren und nachfolgend Strahlen rekombinieren.

Gemäß zumindest einer Ausführungsform umfasst der strahlungsemittierende Bereich dabei zumindest zwei Schichten, die jeweils ein voneinander unterschiedliches Emittermaterial enthalten. So kann beispielsweise das Matrixmaterial ein Emittermaterial enthalten, das im Betrieb des Bauelements blaues Licht emittiert. Ferner kann der strahlungsemittierende Bereich Schichten mit Emittermaterial enthalten, wobei zumindest eine Schicht rotes Licht emittiert und zumindest eine Schicht grünes Licht emittiert.

Im Folgenden wird das hier beschrieben Verfahren sowie das beschriebene Bauelement anhand von Ausführungsbeispielen und den dazugehörigen Figuren näher erläutert.

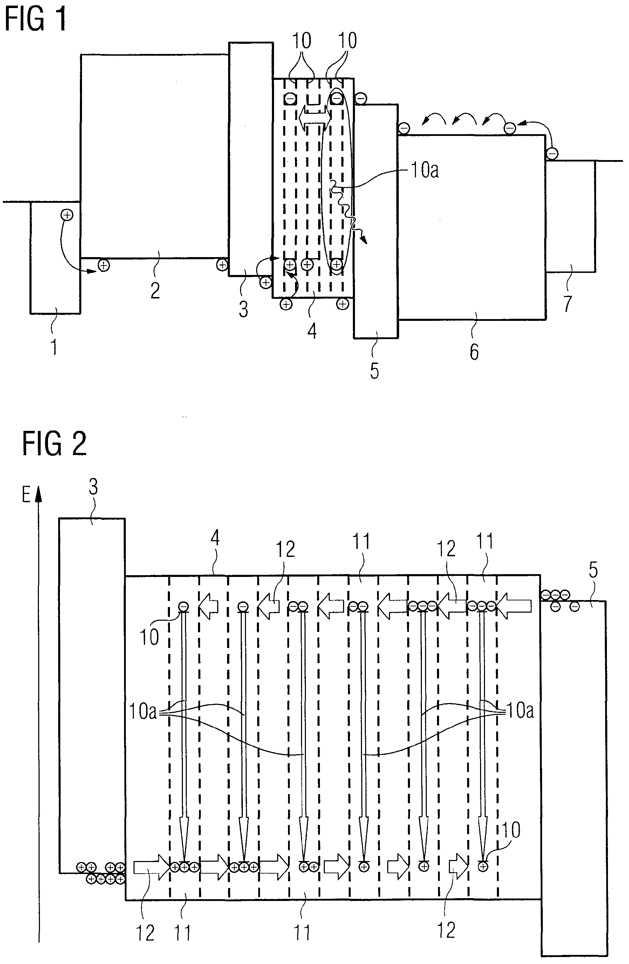

In Verbindung mit den Figuren 1 bis 6 sind anhand schematischer Darstellungen Ausführungsbeispiele des hier beschriebenen organischen, strahlungsemittierenden Bauelements sowie des Verfahrens zu seiner Herstellung näher erläutert.

Gleiche, gleichartige oder gleich wirkende Elemente sind in den Figuren mit denselben Bezugszeichen versehen. Die Figuren und die Größenverhältnisse der in den Figuren dargestellten Elemente untereinander sind nicht als maßstäblich zu betrachten. Vielmehr können einzelne Elemente zur besseren Darstellbarkeit und/oder zum besseren Verständnis übertrieben groß dargestellt sein.

Die Figur 1 zeigt anhand einer schematischen Darstellung den Aufbau eines organischen, strahlungsemittierenden Bauelements gemäß einem Ausführungsbeispiel. Bei dem organischen, strahlungsemittierenden Bauelement handelt es sich beispielsweise um eine organische Leuchtdiode (OLED).

Das Bauelement umfasst als erste Elektrode eine Anode 1. An die Anode 1 grenzt eine Lochtransportschicht 2, welche positive Ladungsträger in den strahlungsemittierenden Bereich 4 transportiert.

Der Lochtransportschicht 2 folgt eine Elektronenbarriereschicht 3 nach, welche das Eindringen von Elektronen aus dem strahlungsemittierenden Bereich 4 in die Lochtransportschicht 2 verhindert.

Der strahlungsemittierende Bereich 4 ist nach einem der hier beschriebenen Ausführungsformen ausgeführt. Ferner ist der strahlungsemittierende Bereich 4 nach einem der hier beschriebenen Verfahren hergestellt. Im strahlungsemittierenden Bereich 4 kommt es zur Emission 10a von elektromagnetischer Strahlung in den Schichten 10, die ein Emittermaterial enthalten.

Dem strahlungsemittierenden Bereich 4 folgt eine Lochbarriereschicht 5 nach, welche das Eindringen von positiven Ladungsträgern in die angrenzende Elektronentransportschicht 6 verhindert.

Die Elektronentransportschicht 6 transportiert negative Ladungsträger, Elektronen, von der als Kathode 7 ausgebildeten zweiten Elektrode zum strahlungsemittierenden Bereich 4.

In Verbindung mit der Figur 2 ist anhand einer schematischen Darstellung ein strahlungsemittierender Bereich 4 für ein Ausführungsbeispiel eines hier beschriebenen Bauelements näher erläutert. Der strahlungsemittierende Bereich umfasst eine Vielzahl von Schichten 10, die jeweils ein Matrixmaterial und ein Emittermaterial enthalten. Die Schichten 10 mit Emittermaterial enthalten vorliegend jeweils das gleiche Emittermaterial, so dass in sämtlichen Schichten 10 mit Emittermaterial eine Emission 10a von elektromagnetischer Strahlung im gleichen Wellenlängenbereich stattfindet. Die Schichten 10 mit Emittermaterial sind in Schichten 11 mit Matrixmaterial eingebettet.

Die Schichten 11 mit Matrixmaterial enthalten vorzugsweise zwei Matrixmaterialien, ein elektronenleitendes Matrixmaterial und ein lochleitendes Matrixaterial. In der Figur 2 ist schematisch dargestellt, dass Ladungsträger an den Grenzschichten von Schichten mit Matrixmaterial 11 mit einer Elektronenbarriereschicht 3 beziehungsweise einer Lochbarriereschicht 5 zunächst blockiert werden, und sich dadurch Raumladungen ausbilden. Ladungsträger werden anschließend in den strahlungsemittierenden Bereich 4 initiiert, wobei sie jeweils in Schichten mit Emittermaterial an Molekülen des Emittermaterials eingefangen werden. Teilweise rekombinieren die Ladungsträger, was die Emission 10a von elektromagnetischer Strahlung zur Folge hat. Teile der Gesamtheit der Ladungsträger tunneln jedoch zu benachbarten Schichten mit Emittermaterial. Die unterschiedliche Länge der dunklen Pfeile in der Figur 2 symbolisiert dabei die Tunnelwahrscheinlichkeit, die von der Zahl der Ladungsträger, der Schichtdicke der Schichten 11 mit Matrixmaterial zwischen den Schichten 10 mit Emittermaterial sowie von der Höhe der Barriere zwischen den Schichten abhängt.

Die Schichtdicke für die Schichten 10 mit Emittermaterial liegt dabei vorzugsweise im Monolagen- oder Submonolagenbereich. Schichtdicken für Schichten, die aus Matrixmaterial bestehen, können dabei ähnlich oder größer gewählt sein. Die beschriebenen geringen Schichtdicken sind insbesondere über Atomlagenabscheidung besonders genau und reproduzierbar herstellbar. Aufgrund der in Figur 2 beschriebenen Anordnung kommt es zu Emission 10a von elektromagnetischer Strahlung über den gesamten strahlungsemittierenden Bereich.

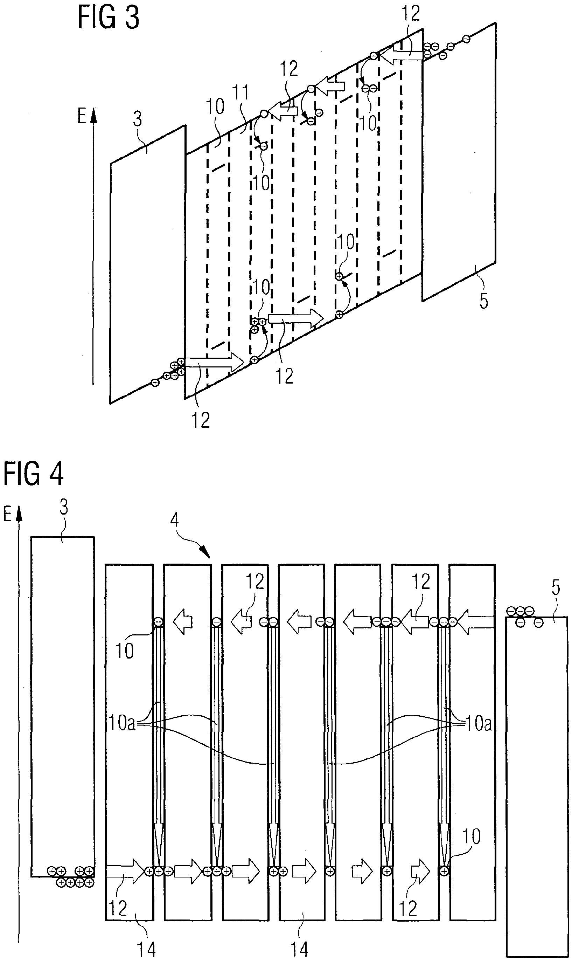

In der Figur 3 ist die in Verbindung mit der Figur 2 beschriebene Situation anhand einer schematischen Perspektivdarstellung nochmals dargestellt. In dieser Darstellung ist besser zu erkennen, dass die Schichten 10 mit Emittermaterial energetisch tiefer liegen als die Schichten 11, welche aus Matrixmaterial bestehen. Auf diese Weise ist zwischen den einzelnen Schichten 10, die ein Emittermaterial enthalten, eine Energiebarriere angeordnet, welche aus dem oder den Matrixmaterialien ohne Emittermaterial gebildet ist.

In Verbindung mit der schematischen Darstellung der Figur 4 ist ein weiteres Ausführungsbeispiel näher erläutert. In diesem Ausführungsbeispiel sind die Schichten 10 mit Emittermaterial, welche ein Matrixmaterial sowie ein Emittermaterial enthalten, im Unterschied zu den Ausführungsbeispielen der Figuren 2 und 3 von Schichten 14 umgeben, die mit Barrierematerial gebildet sind. Das Barrierematerial zeichnet sich durch eine höhere Bandlücke als das Matrixmaterial aus.

Im Ausführungsbeispiel der Figur 4 sind Schichten 10 mit Emittermaterial und Schichten 13, die aus zumindest einem Barrierematerial bestehen, alternierend angeordnet. Ladungsträger in diesem Ausführungsbeispiel haben eine höhere Energiebarriere zu überwinden, um von einer Schicht 10 mit Emittermaterial in eine benachbarte Schicht 10 mit Emittermaterial zu gelangen. Auf diese Weise ist der Ladungsträgereinschluss in den Schichten 10 mit Emittermaterial verbessert.

Das Barrierematerial der Schichten 14 mit Barrierematerial hat dabei sowohl loch- als auch elektronenblockierende Eigenschaften. Es bringt den weiteren Vorteil mit sich, dass - im Unterschied zu einer Struktur, wie sie in Verbindung mit den Figuren 2 und 3 beschrieben ist - insbesondere Exzitonen besonders gut davon abgehalten werden, von einer Schicht 10 mit Emittermaterial in eine andere Schicht 10 mit Emittermaterial zu diffundieren. Das Barrierematerial in den Schichten 14 kann dabei derart gewählt werden, dass es Elektronen besonders gut, Löcher besonders gut, oder beide Ladungsträgersorten gleich gut blockiert. Über die Variation der Dicke der Schichten 14 mit Barrierematerial kann die Tunnelwahrscheinlichkeit zwischen zwei Schichten 10 mit Emittermaterial eingestellt werden. Vorzugsweise werden sämtliche Schichten des strahlungsemittierenden Bereichs 4 dabei mittels Atomlagenabscheidung erzeugt.

Die in Verbindung mit der Figur 4 vorgestellte Struktur kann auch als organische Quantentopfstruktur bezeichnet werden. Sie zeichnet sich insbesondere dadurch aus, dass der Ladungsträgereinfang in den einzelnen Schichten 10 mit Emittermaterial besonders gut ist. Darüber hinaus kann aufgrund des Herstellungsverfahrens - der Atomlagenabscheidung - die Schichtdicke der Emitterschichten besonders gut kontrolliert werden. In Kombination führt das zu einem besonders gut reproduzierbar herstellbaren Bauelement, bei dem die Emission 10a eine besonders geringe Linienbreite aufweist. Das heißt, es kann besonders reines Licht einer bestimmten Wellenlänge oder eines bestimmten Wellenlängenbereichs erzeugt werden. Im Ausführungsbeispiel, das in Verbindung mit der Figur 4 beschrieben ist, findet dabei in jeder Schicht 10 mit Emittermaterial das gleiche Emittermaterial Verwendung.

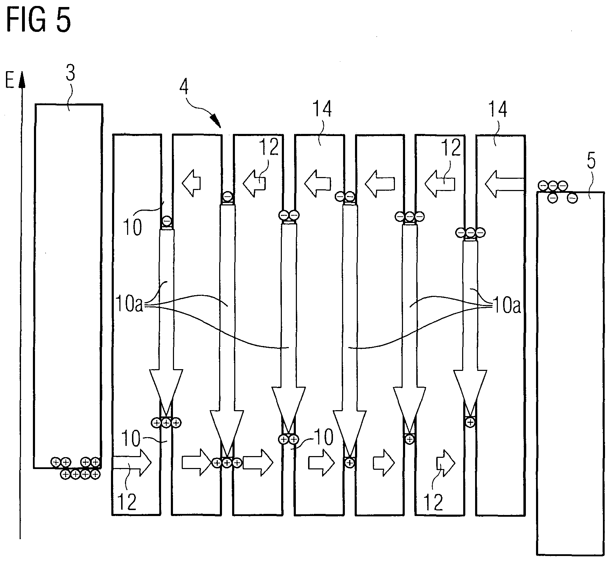

Im Unterschied dazu ist anhand der schematischen Darstellung der Figur 5 ein Ausführungsbeispiel erläutert, bei dem in den Schichten 10 mit Emittermaterial unterschiedliche Emittermaterialien zum Einsatz kommen. Die Dicke der einzelnen Schichten 14 mit Barrierematerial kann dabei an die unterschiedlichen HOMO- und LUMO-Level der verschiedenen Emittermaterialien angepasst werden. Darüber hinaus können in den Schichten 14 mit Barrierematerial unterschiedliche Barrierematerialien Verwendung finden, je nachdem, welches Barrierematerial für den angrenzenden Emitter am besten geeignet ist. Solche Strukturen sind mittels Atomlagenabscheidung besonders einfach herstellbar.

Die Schichten 10 mit Emittermaterial werden dabei an Stellen angeordnet, an denen die Wahrscheinlichkeit für Emission besonders hoch ist. Aufgrund der Verwendung unterschiedlicher Emittermaterialien kann das Bauelement Mischstrahlung aussenden, beispielsweise weißes Licht. Dabei können sich unterschiedliche Emittermaterialien abwechseln, das heißt benachbarte Schichten 10 mit Emittermaterial umfassen jeweils ein unterschiedliches Emittermaterial. Es ist jedoch auch möglich, dass die Schichten mit Emittermaterial jeweils in Gruppen angeordnet werden, wobei jede Gruppe mehrere Schichten 10 mit Emittermaterial umfasst, wobei innerhalb der Gruppe das gleiche Emittermaterial Verwendung findet.

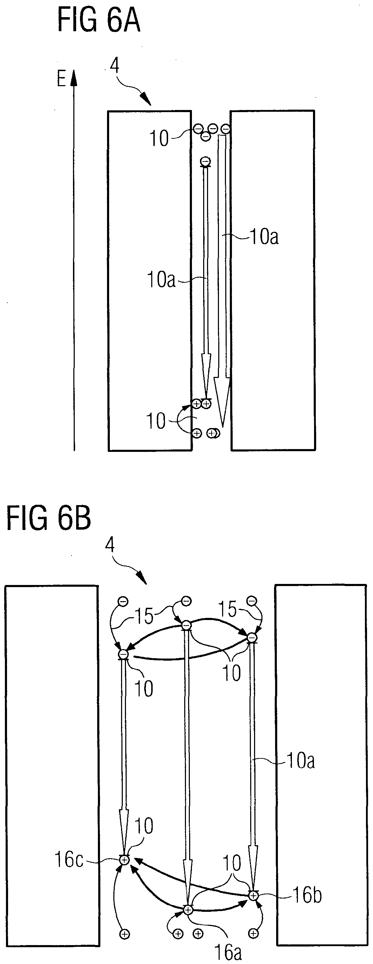

In Verbindung mit den Figuren 6A und 6B ist ein weiteres Ausführungsbeispiel eines hier beschriebenen Bauelements näher erläutert. Die Figuren 6A und 6B zeigen dabei unterschiedliche Möglichkeiten zur Emission von elektromagnetischer Strahlung.

Beim in Verbindung mit der Figur 6A beschriebenen Ausführungsbeispiel sind rote und grüne Emittermaterialien in Schichten 10 eingebracht. Das Matrixmaterial für diese Emittermaterialien, sowie das Matrixmaterial für die Schichten 11, welche aus Matrixmaterial bestehen, ist dabei aus einem blau emittierenden Material gebildet. Auf diese Weise wird also auch von den Schichten 11, die aus einem Matrixmaterial bestehen, elektromagnetische Strahlung emittiert. Die rot und grün emittierenden Materialien emittieren dabei vorzugsweise phosphoreszierend.

In Verbindung mit der Figur 6B ist eine andere Möglichkeit zur Emission von elektromagnetischer Strahlung mit unterschiedlichen Wellenlängen beschrieben. Dabei sind Schichten 10 mit unterschiedlichem Emittermaterial von Schichten 11, die aus Matrixmaterial bestehen, umgeben. Ladungsträger können dabei, wie durch die schwarzen Pfeile 15 symbolisiert, von den Schichten 10 direkt eingefangen werden. Darüber hinaus ist es möglich, dass Ladungsträger beispielsweise vom blauen Emitter 16a eingefangen werden und von dort zu den energetisch niedrig liegenden Emittermaterialien, das heißt zu grünem Emittermaterial 16b und rotem Emittermaterial 16c relaxieren. In diesem Ausführungsbeispiel ist das Matrixmaterial selbst nicht emittierend.

Materialien, die zur Herstellung einer hier beschrieben Bauelements geeignet sind, sind zum Beispiel in der Druckschrift DE 102007058005.5 beschrieben.

Die Erfindung ist nicht durch die Beschreibung anhand der Ausführungsbeispiele auf diese beschränkt. Vielmehr umfasst die Erfindung jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder Ausführungsbeispielen angegeben ist.

## Patentansprüche

1. Verfahren zur Herstellung eines organischen, strahlungsemittierenden Bauelements, bei dem der strahlungsemittierende Bereich (4) zumindest zwei Schichten (11) umfasst, die jeweils aus zumindest einem Matrixmaterial bestehen und mittels Atomlagenabscheidung hergestellt werden, wobei zumindest eine Schicht (10), die ein Emittermaterial enthält, zwischen zwei Schichten (11) aus Matrixmaterial angeordnet ist, wobei die zumindest eine Schicht (10) eine Dicke von höchstens 2 nm aufweist,
- wobei das Matrixmaterial durch ein fluoreszierendes Emittermaterial gebildet ist, das eingerichtet ist, Strahlung im Wellenlängenbereich von blauem Licht zu emittieren, und
- wobei in dem strahlungsemittierenden Bereich (4) zumindest eine weitere Schicht (10) und damit zumindest zwei Schichten (10) erzeugt werden, die mittels Atomlagenabscheidung hergestellt werden und jeweils ein voneinander unterschiedliches phosphoreszierendes Emittermaterial enthalten, das dazu eingerichtet ist, Strahlung mit größeren Wellenlängen als blaues Licht zu emittieren.

2. Verfahren gemäß dem vorherigen Anspruch,
wobei im strahlungsemittierenden Bereich (4) des Bauelements zumindest eine Schicht (14) erzeugt wird, die aus zumindest einem Barrierematerial besteht, und wobei das Barrierematerial eine größere Bandlücke als das Matrixmaterial aufweist.

3. Verfahren gemäß dem vorherigen Anspruch,
wobei die zumindest eine Schicht (14), die aus dem zumindest einen Barrierematerial besteht, mittels Atomlagenabscheidung hergestellt wird.

4. Organisches, strahlungsemittierendes Bauelement mit
- einem strahlungsemittierenden Bereich (4), in dem im Betrieb des Bauelements elektromagnetische Strahlung erzeugt wird,
bei dem der strahlungsemittierende Bereich (4) zumindest zwei Schichten (11) umfasst, die jeweils aus zumindest einem Matrixmaterial bestehen, wobei zumindest eine Schicht (10), die ein Emittermaterial enthält, zwischen zwei Schichten (11) aus Matrixmaterial angeordnet ist, wobei die zumindest eine Schicht (10) eine Dicke von höchstens 2 nm aufweist,
- das Matrixmaterial durch ein fluoreszierendes Emittermaterial gebildet ist, das eingerichtet ist, Strahlung im Wellenlängenbereich von blauem Licht zu emittieren, und
- der strahlungsemittierende Bereich (4) zumindest eine weitere Schicht (10) und damit zumindest zwei Schichten (10) umfasst, die jeweils ein voneinander unterschiedliches phosphoreszierendes Emittermaterial enthalten, das dazu eingerichtet ist, Strahlung mit größeren Wellenlängen als blaues Licht zu emittieren.

5. Organisches, strahlungsemittierendes Bauelement gemäß Anspruch 4,
bei dem
- der strahlungsemittierende Bereich (4) zumindest zwei Schichten (11) umfasst, wobei jede der Schichten (11) aus zumindest einem elektronenleitenden Matrixmaterial und zumindest einem lochleitenden Matrixmaterial besteht, die in der Schicht miteinander vermischt sind, und
- zumindest eine Schicht (10), die ein Emittermaterial enthält, zwischen zwei Schichten (11) aus Matrixmaterial angeordnet ist.

6. Organisches, strahlungsemittierendes Bauelement gemäß einem der Ansprüche 4 bis 5,
bei dem der strahlungsemittierende Bereich (4) zumindest eine Schicht (14) umfasst, die aus zumindest einem Barrierematerial besteht, wobei das Barrierematerial eine größere Bandlücke als das Matrixmaterial aufweist.

7. Organisches, strahlungsemittierendes Bauelement gemäß Anspruch 6,
bei dem der strahlungsemittierende Bereich (4) zumindest zwei Schichten (14) umfasst, die jeweils aus zumindest einem Barrierematerial bestehen, wobei zumindest eine Schicht (10), die ein Emittermaterial enthält, zwischen zwei Schichten (14) aus Barrierematerial angeordnet ist.

## Claims

1. Method for producing an organic radiation-emitting component, wherein the radiation-emitting region (4) comprises at least two layers (11) which each consist of at least one matrix material and are produced by means of atomic layer deposition, wherein at least one layer (10) containing an emitter material is arranged between two layers (11) composed of matrix material, wherein the at least one layer (10) has a thickness of at most 2 nm,
- wherein the matrix material is formed by a fluorescent emitter material that is designed to emit radiation in the wavelength range of blue light, and
- wherein there are produced in the radiation-emitting region (4) at least one further layer (10) and thus at least two layers (10) which are produced by means of atomic layer deposition and each contain a mutually different phosphorescent emitter material that is designed to emit radiation having higher wavelengths than blue light.

2. Method according to the preceding claim,
wherein at least one layer (14) consisting of at least one barrier material is produced in the radiation-emitting region (4) of the component, and wherein the barrier material has a larger band gap than the matrix material.

3. Method according to the preceding claim,
wherein the at least one layer (14) consisting of the at least one barrier material is produced by means of atomic layer deposition.

4. Organic, radiation-emitting component comprising
- a radiation-emitting region (4), in which electromagnetic radiation is generated during the operation of the component,
wherein the radiation-emitting region (4) comprises at least two layers (11) each consisting of at least one matrix material, wherein at least one layer (10) containing an emitter material is arranged between two layers (11) composed of matrix material, wherein the at least one layer (10) has a thickness of at most 2 nm,
- the matrix material is formed by a florescent emitter material that is designed to emit radiation in the wavelength range of blue light, and
- the radiation-emitting region (4) comprises at least one further layer (10) and thus at least two layers (10) which each contain a mutually different phosphorescent emitter material that is designed to emit radiation having higher wavelengths than blue light.

5. Organic, radiation-emitting component according to Claim 4,
wherein
- the radiation-emitting region (4) comprises at least two layers (11), wherein each of the layers (11) consists of at least one electron-conducting matrix material and at least one hole-conducting matrix material which are mixed with one another in the layer, and
- at least one layer (10) containing an emitter material is arranged between two layers (11) composed of matrix material.

6. Organic, radiation-emitting component according to either of Claims 4 and 5,
wherein the radiation-emitting region (4) comprises at least one layer (14) consisting of at least one barrier material, wherein the barrier material has a larger band gap than the matrix material.

7. Organic, radiation-emitting component according to Claim 6,
wherein the radiation-emitting region (4) comprises at least two layers (14) each consisting of at least one barrier material, wherein at least one layer (10) containing an emitter material is arranged between two layers (14) composed of barrier material.

## Revendications

1. Procédé de fabrication d'un composant rayonnant organique, dans lequel la zone émettant un rayonnement (4) comprend au moins deux couches (11), qui sont constituées respectivement d'au moins un matériau de matrice et sont fabriquées au moyen d'un procédé de dépôt de couches minces atomiques, dans lequel au moins une couche (10), qui contient un matériau émetteur, est disposée entre deux couches (11) de matériau de matrice, dans lequel au moins une couche (10) présente une épaisseur maximale de 2 nm,
- dans lequel le matériau de matrice est formé par un matériau émetteur fluorescent, qui est conçu afin d'émettre un rayonnement dans la plage de longueur d'onde de lumière bleue et
- dans lequel dans la zone émettant un rayonnement (4) au moins une couche supplémentaire (10) et ainsi au moins deux couches (10) sont générées, qui sont fabriquées par dépôt de couches minces atomiques et contiennent respectivement un matériau émetteur phosphorescent différent l'un de l'autre, qui est conçu afin de d'émettre un rayonnement avec une longueur d'onde plus grande que la lumière bleue.

2. Procédé selon la revendication précédente, dans lequel dans la zone émettant un rayonnement (4) du composant au moins une couche (14) est générée, qui est constitué d'au moins un matériau de barrière et dans lequel le matériau de barrière présente une bande interdite plus grande que le matériau de matrice.

3. Procédé selon la revendication précédente, dans lequel au moins une couche (14), qui est constitué d'au moins un matériau de barrière, est fabriquée au moyen d'un dépôt de couches minces atomiques.

4. Composant organique rayonnant comportant
- une zone émettant un rayonnement (4), dans laquelle pendant le fonctionnement du composant un rayonnement électromagnétique est généré, dans lequel la zone émettant un rayonnement (4) comprend au moins deux couches (11), qui sont constituées respectivement d'au moins un matériau de matrice, dans lequel au moins une couche (10), qui contient un matériau émetteur, est disposée entre deux couches (11) de matériau de matrice, dans lequel au moins une couche (10) présente une épaisseur maximale de 2 nm,
- le matériau de matrice est formé par un matériau émetteur fluorescent, qui est conçu afin d'émettre un rayonnement dans la plage de longueur d'onde de lumière bleue et
- la zone émettant un rayonnement (4) comprend au moins une couche supplémentaire (10) et ainsi au moins deux couches (10), qui contiennent respectivement un matériau émetteur phosphorescent différent l'un de l'autre, qui est conçu afin d'émettre un rayonnement avec une longueur d'onde plus grande que la lumière bleue.

5. Composant organique rayonnant selon la revendication 4, dans lequel
- la zone émettant un rayonnement (4) comprend au moins deux couches (11), dans lequel chacune des couches (11) est constituée d'au moins un matériau de matrice conducteur d'électrons et d'au moins un matériau de matrice conducteur de trous, qui sont mélangés l'un avec l'autre dans la couche et
- au moins une couche (10), qui contient un matériau émetteur, est disposée entre deux couches (11) de matériau de matrice.

6. Composant organique rayonnant selon une des revendications 4 à 5, dans lequel la zone émettant un rayonnement (4) comprend au moins une couche (14), qui est constituée d'au moins un matériau de barrière, dans lequel le matériau de barrière présente une plus grande bande interdite que le matériau de matrice.

7. Composant organique rayonnant selon la revendication 6, dans lequel la zone émettant un rayonnement (4) comprend au moins deux couches (14), qui sont constituées respectivement d'au moins un matériau de barrière, dans lequel au moins une couche (10), qui contient un matériau émetteur, est disposée entre deux couches (14) de matériau de barrière.
